(19) Europäisches Patentamt
European Patent Office
Office européen des brevets

(11) **EP 2 784 803 B1**

(12) **FASCICULE DE BREVET EUROPEEN**

(45) Date de publication et mention
de la délivrance du brevet:
**18.11.2020 Bulletin 2020/47**

(51) Int Cl.:
*H01L 21/306* (2006.01)       *H01L 21/3065* (2006.01)
*H01L 31/0236* (2006.01)      *H01L 31/0216* (2014.01)

(21) Numéro de dépôt: **14155317.2**

(22) Date de dépôt: **17.02.2014**

(54) **Procédé de gravure autolimité à niveaux multiples**

Auf mehreren Ebenen selbst beschränkendes Ätzverfahren

Self-limiting etching method with multiple levels

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.02.2013 FR 1351606**

(43) Date de publication de la demande:
**01.10.2014 Bulletin 2014/40**

(73) Titulaires:
• **COMMISSARIAT À L'ÉNERGIE ATOMIQUE ET AUX ÉNERGIES ALTERNATIVES**
**75015 Paris (FR)**
• **Centre National de la Recherche Scientifique**
**75016 Paris (FR)**

(72) Inventeurs:
• **Desplats, Olivier**
**38100 Grenoble (FR)**
• **Chevolleau, Thierry**
**38000 GRENOBLE (FR)**
• **Darnon, Maxime**
**38610 GIERES (FR)**
• **Gourgon, Cécile**
**38110 CESSIEU (FR)**

(74) Mandataire: **Decobert, Jean-Pascal**
**Cabinet Hautier**
**20, rue de la Liberté**
**06000 Nice (FR)**

(56) Documents cités:

US-A- 4 778 583    US-A1- 2012 315 716

• **KENNEDY K ET AL: "FABRICATION OF V-GROOVE GRATINGS IN INP BY INDUCTIVELY COUPLED PLASMA ETCHING WITH SICL4/AR", SEMICONDUCTOR SCIENCE AND TECHNOLOGY, IOP PUBLISHING LTD, GB, vol. 21, no. 1, 28 novembre 2005 (2005-11-28), pages L01-L05, XP001243890, ISSN: 0268-1242, DOI: 10.1088/0268-1242/21/1/L01**
• **GOMEZ SERGI ET AL: "Etching of high aspect ratio structures in Si using SF6/O2 plasma", JOURNAL OF VACUUM SCIENCE AND TECHNOLOGY: PART A, AVS /AIP, MELVILLE, NY., US, vol. 22, no. 3, 1 mai 2004 (2004-05-01), pages 606-615, XP012073616, ISSN: 0734-2101, DOI: 10.1116/1.1710493**
• **WINDERBAUM S ET AL: "Reactive ion etching (RIE) as a method for texturing polycrystalline silicon solar cells", SOLAR ENERGY MATERIALS AND SOLAR CELLS, ELSEVIER SCIENCE PUBLISHERS, AMSTERDAM, NL, vol. 46, no. 3, 1 juin 1997 (1997-06-01), pages 239-248, XP004084204, ISSN: 0927-0248, DOI: 10.1016/S0927-0248(97)00011-1**
• **SATO MASAAKI ET AL: "Control of etching-product-dependent shape and selectivity in gate polysilicon reactive ion etching", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 16, no. 3, 1 mai 1998 (1998-05-01), pages 1038-1042, XP012006759, ISSN: 0734-211X, DOI: 10.1116/1.590064**

**Description**

DOMAINE TECHNIQUE DE L'INVENTION

La présente invention concerne en général la fabrication de dispositifs microélectroniques à base de matériaux semi-conducteurs et notamment les dispositifs optoélectroniques produits par l'industrie de la microélectronique et en particulier les moyens anti-réfléchissants utilisés pour améliorer l'efficacité de conversion optique électrique de ces dispositifs.

ÉTAT DE LA TECHNIQUE

Les dispositifs optoélectroniques produits par l'industrie de la microélectronique, en particulier les cellules solaires et les détecteurs optiques, qu'ils soient conçus pour fonctionner dans le domaine des infrarouges (IR) ou dans celui des longueurs d'ondes visibles, utilisent toujours des moyens anti-réfléchissants de façon à maximiser le nombre de photons incidents absorbés par le semi-conducteur sous-jacent afin de convertir la lumière en énergie électrique avec le plus d'efficacité possible.

Une technique simple et peu coûteuse, et donc très largement utilisée, consiste à recouvrir la surface du dispositif d'une ou plusieurs couches minces de matériaux transparents anti-réfléchissants. Les épaisseurs et matériaux sont choisis pour provoquer des interférences destructrices des ondes réfléchies et au contraire favoriser la transmission des ondes incidentes. Du fait même du principe de fonctionnement, basé sur l'alternance des indices de réfraction des différentes couches, l'efficacité de cette technique, globalement désignée par l'acronyme ARC de l'anglais « antireflective coating », est cependant très dépendante de la gamme des longueurs d'ondes et aussi de l'angle d'incidence des rayonnements lumineux qu'il faut pouvoir détecter. Par ailleurs, le dépôt d'une couche d'un ou plusieurs matériaux étrangers sur la surface du dispositif pose généralement des problèmes d'adhérence et de stabilité à long terme de ces couches, problèmes qui peuvent être aggravés par un comportement thermique différent de celles-ci vis-à-vis du corps du dispositif.

Une autre approche qui a été explorée par la communauté scientifique qui travaille dans ce domaine consiste à créer des reliefs à la surface du dispositif optoélectronique. Ces reliefs sont de dimensions adaptées à la gamme des longueurs d'ondes à détecter. Dans cette approche, on s'arrange donc pour créer une structuration de la surface qui empêche que le rayonnement incident puisse être réfléchi, sinon en totalité, tout au moins en très grande partie. Un tel système, et une revue de moyens connus, ont par exemple été décrits dans un article publié en langue anglaise, le 1er mai 2010, dans le volume 35, numéro 9, de « Optics Letters » une publication de « Optical Society of America » sous le titre « Sand-castle biperiodic pattern for spectral and angular broadening of antireflective properties » par R. Bouffaron et ses coauteurs.

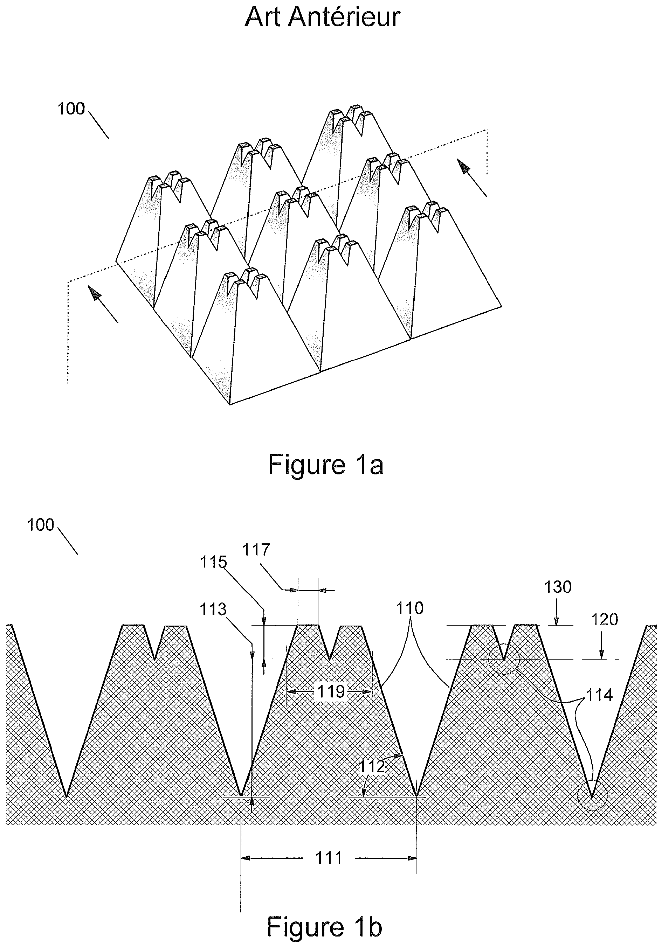

Cet article montre qu'une structure anti-réfléchissante très efficace, c'est-à-dire qui fonctionne dans une large gamme de longueurs d'ondes et d'angles d'incidence du rayonnement à détecter, peut être obtenue par la répétition de motifs en relief de forme pyramidale à base carrée et à double périodicité qui est qualifiée de « sand-castle » c'est-à-dire de « château de sable » du fait de la présence de deux niveaux de pyramides suivant la hauteur. Une représentation tridimensionnelle de la structure anti-réfléchissante 100 formée de ces motifs en relief 110 est reproduite sur la figure 1a. La figure 1b est une coupe transversale 101 de ces derniers où l'on distingue deux niveaux, 120 et 130, de motifs pyramidaux superposés. Pour obtenir l'efficacité attendue de cette double structure pyramidale, d'une part il faut que le contrôle de la pente 112 des deux niveaux soit maîtrisé sans rupture de continuité entre ceux-ci. D'autre part, l'efficacité de la structure dépend fortement de l'absence de surface plane au bas des motifs. Pour obtenir un anti-reflet optimal il est nécessaire que le fond 114 des motifs 110 forme bien un V.

Cette structuration de surface 100 est donc constituée d'un réseau de motifs en relief 110 couvrant la surface du dispositif et dont l'élément unitaire est un château de sable sur deux niveaux comme dans l'exemple des figures 1a et 1b. Dans un exemple particulier de mise en œuvre, la grande base 111 du château de sable, qui est aussi la période du réseau, a une dimension de 1 micron ou $\mu m$ c'est-à-dire $10^{-6}$ mètre. Les dimensions des motifs sont avantageusement choisies pour limiter la réflexion dans une gamme de longueur d'ondes comprises entre 500 nm et 5 $\mu m$. La hauteur 113 du premier niveau ou niveau inférieur est de 1,25 $\mu m$ et le plateau supérieur ou mésa 119 de ce premier niveau a une largeur de 500 nanomètres ou nm, c'est-à-dire $10^{-9}$ mètre. Les pyramides tronquées du second niveau ou niveau supérieur ont un rapport de dimensions identique à ceux du premier niveau, ainsi la base d'une pyramide a un côté de 250 nm, sa hauteur 115 est de 312,5 nm alors que le mésa supérieur 117 a un côté qui fait 125 nm.

Si la publication ci-dessus donne bien tous les avantages potentiels de l'utilisation de la structure décrite dans les figures 1a et 1b, elle ne dit cependant rien de la façon dont on peut former en pratique celle-ci à la surface d'un dispositif optoélectronique du type de ceux produits par l'industrie de la microélectronique. La publication ne mentionne en effet que le fait que cette structure pourrait être obtenue par la technique connue de « nanoimprint » c'est-à-dire par impression de motifs de tailles nanométriques, ce qui pose le problème de la fabrication du moule de nanoimpression lui-même et suppose implicitement que les motifs sont imprimés dans une couche d'un matériau qui est effectivement suffisamment malléable pour être imprimable avec les inconvénients mentionnés plus haut du dépôt préalable d'une couche d'un matériau étranger sur la surface du dispositif optoélectronique.

Un procédé de réalisation de motifs comprenant des flancs inclinés à partir d'une face d'un substrat InP est décrit dans le l'article de Kennedy K sous le titre "Fabrication of V-groove gratings in Inp by inductively coupled plasma etching with SiCl4/Ar", Semiconductor Science and Technology, IOP publishing Ltd, GB, vol. 21, no. 1, 28 novembre 2005 (2005-11-28), pages L01-05.

C'est donc un objet de l'invention que de proposer un procédé permettant de surmonter tout ou partie des inconvénients de l'art antérieur pour améliorer la réalisation de motifs, en particulier en pentes, en surface d'un matériau et, suivant une application avantageuse non limitative, de décrire un procédé de fabrication de la structure pyramidale illustrée dans les figures 1a et 1b qui peut être mis en œuvre industriellement dans le cadre d'une chaîne de fabrication de dispositifs optoélectroniques.

D'autres objets, caractéristiques et avantages de la présente invention apparaîtront à l'examen de la description suivante et des dessins d'accompagnement. Il est entendu que d'autres avantages peuvent être incorporés.

## RÉSUMÉ DE L'INVENTION

L'invention concerne un procédé de réalisation de motifs comprenant des flancs inclinés à partir d'une face d'un substrat tel que défini par la revendication 1.

Selon l'invention, des motifs pourtant parfois complexes peuvent être exécutés avec une seule opération de gravure. En outre, l'arrêt de la gravure en fond de motif est automatique. L'invention tire de manière ingénieuse profit de la passivation produite lors de la gravure et en fait un avantage pour l'ensemble du procédé de fabrication.

Selon l'invention, la passivation est avantageusement entretenue par introduction dans la chambre de gravure d'au moins une espèce participant à la réaction de passivation et qui pourrait manquer sans cet apport si bien que la passivation s'arrêterait sans elle.

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

- les figures 1a et 1b illustrent une structure anti-réfléchissante faite de motifs en relief que l'on peut créer avec le procédé de l'invention à la surface d'un dispositif optoélectronique.
- La figure 2 montre un exemple de masque unique qui va servir à définir la structure des motifs en relief sur deux niveaux que l'on obtiendra après gravure.
- La figure 3 montre le profil bombé des flancs des pyramides et la non autolimitation d'une gravure utilisant un plasma de type $Cl_2:O_2$.
- La figure 4 résume les étapes du procédé de l'invention avec trois phases vues chacune de dessus sur la partie gauche de la figure et en coupe transversale sur la partie droite de la figure.
- Les figures 5a et 5b montrent des pyramides à deux niveaux obtenues avec le procédé de l'invention.
- La figure 6 illustre la possibilité offerte par le procédé de l'invention de réaliser une structuration de surface sur plus de deux niveaux.

Les dessins joints sont donnés à titre d'exemples et ne sont pas limitatifs de l'invention.

## DESCRIPTION DÉTAILLÉE DE L'INVENTION

L'invention s'adresse à la fabrication de tout dispositif tel que notamment, ceux indiqués précédemment. Ces fabrications impliquent des substrats ici définis comme des structures à au moins une couche de matériau, très avantageusement du type semi-conducteur, et formant un empilement ou encore une tranche de matériau(x) semi-conducteur(s). Le substrat peut former tout ou partie du dispositif microélectronique final ou être un élément intermédiaire au moins partiellement éliminé en cours de fabrication, par exemple en servant de support ou poignée pour la réalisation et/ou le transfert de couches fonctionnelles. On entend par face du substrat une partie de la surface du substrat exposée vers l'extérieur et typiquement l'une des deux faces délimitant l'épaisseur du substrat. Cette face est non limitativement mais avantageusement plane avant mise en œuvre de l'invention.

Les motifs obtenus en référence aux dessins ne présentent qu'un exemple avantageux. On entend par flanc incliné le fait qu'un motif comprend une pente, ici progressivement formée en creux à partir de la face du substrat, en réalisant un profil concave à la surface du substrat. Ce profil est préférentiellement rectiligne, l'inclinaison étant avantageusement constante au cours de la gravure, ce qui n'exclut pas des variations souhaitées ou inhérentes aux tolérances de fabrication.

Les motifs sont formés progressivement par la gravure autour de zones masquées. Ces zones sont, dans les illustrations, des ilots de surface sur la face du substrat. Ces zones pourraient avoir d'autres configurations et notamment avoir au moins pour certaines au moins des zones de contact ou de continuité. Par exemple quatre zones peuvent être formées par quatre bordures d'un cadre de section rectangulaire ou circulaire. D'une manière générale, les zones masquées sont avantageusement configurées pour définir des espaces intermédiaires au niveau desquels des flancs sont gravés, avec un point haut au niveau des zones masquées, de sorte à se rejoindre en un point bas d'intersection.

Le procédé de l'invention décrit ci-après s'arrange pour produire la structuration à au moins deux niveaux souhaitée, telle que celle décrite dans les figures 1a et 1b, au cours d'une étape de photolithographie avantageusement unique, suivie d'une opération de gravure plasma unique.

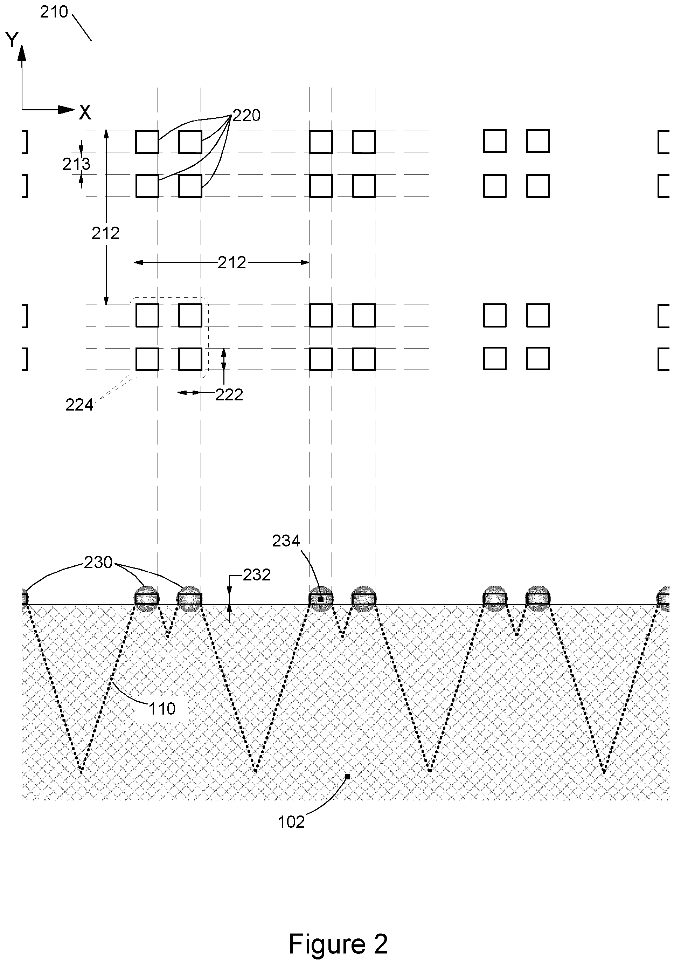

La **figure 2** montre un exemple de masque unique 210 qui va servir à définir la structure 100 des motifs en relief 110 sur deux niveaux que l'on obtiendra après gravure.

Le masque reproduit par des zones marquées les sommets des pyramides tronquées du niveau supérieur 130 et leur pas de répétition dans le plan X-Y. Le pas de répétition horizontal et vertical 212 est donc conforme à la largeur 111 de la base de la pyramide tronquée du niveau inférieur. Les zones 220 du masque sont quant à elles conformes aux sommets des pyramides tronquées du niveau supérieur 130. Leur largeur 222 est donc définie par la largeur 117 des sommets des pyramides du niveau supérieur et ils s'inscrivent dans le carré 224 défini par la largeur 119 du sommet des pyramides du niveau inférieur 120. Les dimensions sont par exemple celles mentionnées dans le chapitre sur l'état de la technique.

En employant des techniques de photolithographie et de gravure les motifs 220 du masque sont tout d'abord transférés à la surface du matériau à graver sous la forme d'un masque dit dur 230, de l'anglais « hard mask (HM) ». Le but du masque dur est de protéger les zones qui ne doivent pas être gravées. D'une façon générale, il est donc fait d'un matériau 234 et est d'une épaisseur 232 qui lui permettront de résister suffisamment longtemps à l'opération de gravure qui va suivre. Dans le cadre de l'invention, le matériau à graver 102, dans lequel on va réaliser la structure anti-réfléchissante 100, est typiquement du silicium (Si). Le matériau 234 du masque dur 230 peut être du dioxyde de silicium (SiO$_2$). Il est de préférence en un matériau sélectionné pour être insensible à la gravure à opérer ensuite.

Pour réaliser le motif pyramidal à deux niveaux 110 décrit dans les figures 1a et 1b, on a recours à une gravure de type plasma. On peut utiliser des réacteurs de gravure dans lesquels on crée un plasma de gravure. Ils peuvent permettre la formation des flancs en pente des motifs 110 en ayant recours notamment à un plasma de type Cl2:O2 c'est-à-dire à base de chlore et d'oxygène. En effet, les espèces chlorées permettent de graver le silicium tout en formant des espèces de type Si-Cl$_X$. Celles-ci sont adsorbées par toutes les surfaces exposées au plasma et en particulier par les parois du réacteur et aussi par les flancs des motifs d'où elles peuvent désorber pour être re-gravées par le chlore du plasma ou être oxydées par l'oxygène du plasma. La réaction de ces espèces Si-Cl$_X$ volatiles avec les espèces oxygénées du plasma conduit à la formation de complexes d'oxyde de silicium halogénés de type Si-O$_x$-Cl$_y$ qui ne sont pas volatils. De plus, ces complexes Si-O$_x$-Cl$_y$ ne réagissent pas chimiquement avec les espèces du plasma et ne peuvent plus être réduits lors de la gravure. Ainsi, le procédé de gravure plasma brièvement décrit ci-dessus fait croître peu à peu au cours de la gravure une couche de passivation ce qui permet d'obtenir une gravure en pente qui est apte à former les flancs des pyramides. La passivation est contrôlée par la quantité de Si-Cl$_X$ produite lors de la gravure et par la densité d'oxygène du plasma. La pente instantanée au pied du motif pendant la gravure est définie par la vitesse de croissance de la couche de passivation et par la vitesse de gravure. La passivation forme typiquement par oxydation une couche d'un matériau moins corrodable que son support et assure dans le cas présent une protection contre la poursuite de la gravure à un endroit passivé des espaces intermédiaires.

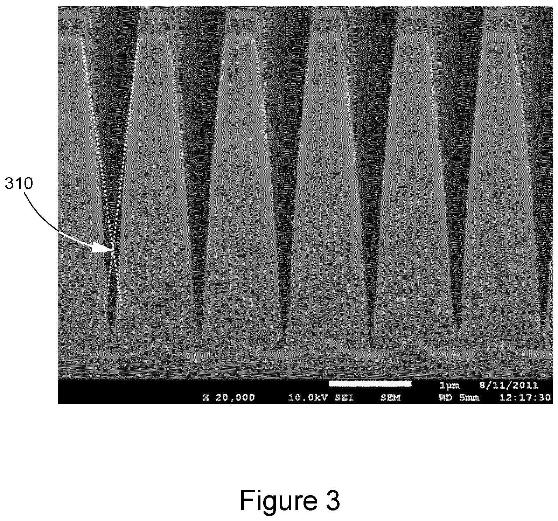

Cependant, le château de sable à au moins deux niveaux 110 de la structure anti-réfléchissante 100 peut être obtenu selon l'invention en ayant recours à au moins un troisième gaz outre la gravure à base d'un plasma de type Cl2:O2. En effet, dans les conditions données au paragraphe précédent, la quantité de Si-Cl$_X$ produite lors de la gravure diminue à mesure que la profondeur atteinte augmente car la formation de flancs en pente réduit la surface de silicium gravé entre les pyramides. Ainsi, l'angle de la pente des flancs n'est pas constant sur toute la hauteur de la pyramide. Il tend à augmenter quand la quantité de Si-Cl$_X$ diminue. La vitesse de croissance de la couche de passivation décroissant on forme alors un profil bombé. De plus la gravure se poursuit dans ce cas entre les pyramides sans jamais se bloquer conduisant les flancs de pyramide à être quasiment verticaux pour de très grandes profondeurs. Le profil bombé des flancs des pyramides et la non autolimitation de la gravure sont illustrés 310 par la **figure 3** qui montre une photo prise au microscope électronique à balayage (MEB) de pyramides réalisées dans un plasma Cl2:O2 comme décrit ci-dessus.

Le procédé de l'invention apporte une solution à ce problème en ajoutant un troisième gaz au mélange gazeux Cl$_2$:O2 ou autre, nécessaire à la gravure. Le gaz ajouté est avantageusement du tétrachlorure de silicium (SiCl$_4$). Il a en effet été remarqué que la présence de celui-ci permettait de conserver une quantité d'espèces SiCl$_X$ quasi constante tout au long de la gravure, et de s'affranchir de la variation de la quantité de Si-Cl$_X$ qui apparaît dans le cas d'un plasma

à deux gaz $Cl_2:O_2$.

D'une manière générale, on peut déterminer la quantité de l'espèce participant à la réaction formant la couche de passivation, au cours de la gravure. Et on ajuste en conséquence l'apport en gaz additionnel. La quantité de l'espèce en question peut ainsi, préférentiellement, être maintenue constante.

Cette solution permet la jonction entre deux pyramides successives à une profondeur fixée par la vitesse de croissance latérale de la couche de passivation. En effet, la quantité constante de $SiCl_x$ dans le plasma induit une vitesse de croissance constante de la couche de passivation des flancs de gravure et permet donc, d'une part, de bloquer localement la gravure lorsque les couches de passivation de deux pyramides voisines se rejoignent et, d'autre part, de former comme il est souhaitable un fond de gravure en V. La gravure se poursuit tout autour sur les surfaces non passivées.

Ainsi, le procédé de gravure de l'invention est autolimitant. La gravure s'arrête automatiquement lorsque les pyramides sont créées c'est-à-dire dès que les flancs inclinés se sont rejoints pour former un fond de gravure en V.

Très avantageusement, l'autolimitation de la gravure apportée par le procédé de l'invention permet donc la réalisation de plusieurs niveaux de gravure au cours d'une même opération. En combinaison avec la conception d'un masque tel que celui décrit dans la figure 2, on peut alors, au cours d'une seule étape globale de photolithographie et de gravure, obtenir la structure anti-réfléchissante 100 à deux niveaux illustrée dans les figures 1a et 1b du chapitre sur l'état de la technique.

Les conditions typiques de mise en œuvre du procédé de l'invention dans une chambre de gravure dans laquelle on forme un plasma alimenté avec les gaz ci-dessus peuvent être :

pression de la chambre : 20 milli Torr ;
puissance de la source : 1000 watts ;
puissance de polarisation (bias) : 150 watts ;
débit de chlore ($Cl_2$) : 40 sccm (standard centimètres cube par minute) ;
débit de tétrachlorure de silicium ($SiCl_4$) : 40 sccm ;
débit d'oxygène ($O_2$) : 25 sccm.

À l'issue de l'opération de gravure, un nettoyage est effectué pour retirer le masque dur en oxyde de silicium et les couches de passivation qui se sont formées sur les flancs pendant la gravure. Cette opération est réalisée de préférence par attaque chimique dans un milieu acide, typiquement en utilisant de l'acide fluorhydrique (HF).

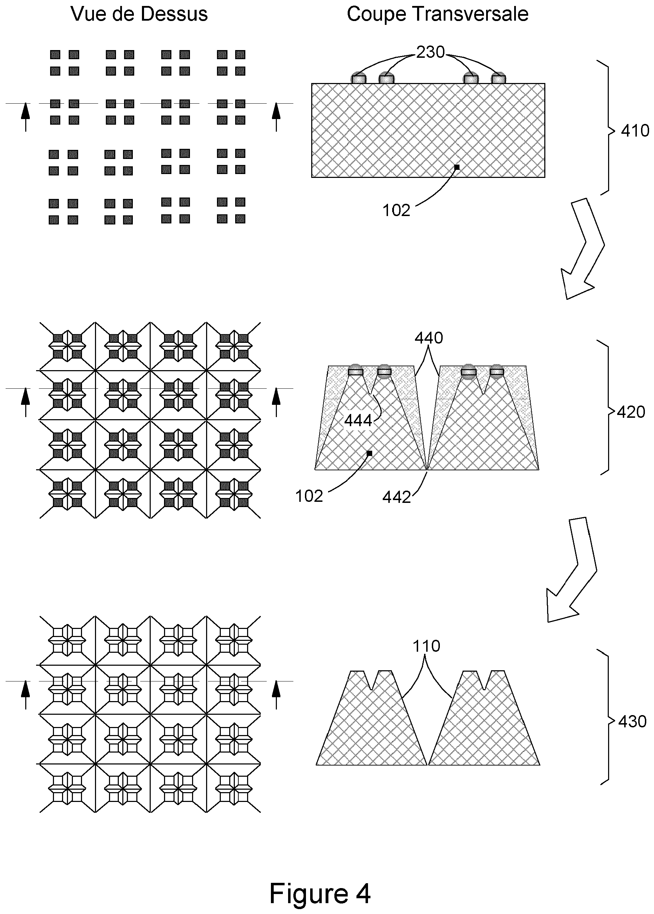

La **figure 4** résume les étapes d'un mode de réalisation du procédé de l'invention.

Au cours d'une première étape 410, on procède à la formation du masque dur 230 en surface du matériau à graver. Le matériau à graver est par exemple un substrat fait ou à base de silicium 102 ou une couche superficielle faite ou à base de silicium d'un substrat. Le masque dur définit les zones 220 représentant le haut des pyramides tronquées du niveau supérieur 130 comme expliqué en figure 2. Le masque dur est de préférence obtenu par photolithographie et gravure d'une couche d'un matériau préalablement déposé et susceptible de protéger le silicium lors de la gravure plasma, laquelle permet de créer les motifs pyramidaux formant la structuration de surface.

Lors de la deuxième étape 420, on procède à la gravure plasma des motifs en relief 110. Comme expliqué, dans les conditions décrites pour la mise en œuvre du procédé de l'invention, il y a formation et croissance continue d'une couche de passivation 440 entraînant une gravure en pente des flancs, la surface gravée se réduisant avec l'augmentation de la profondeur gravée. La gravure du silicium 402 s'arrête automatiquement quand les flancs de la couche de passivation se rejoignent au fond des motifs 442 protégeant ainsi complètement le matériau sous-jacent. Le même phénomène 444 s'est d'abord produit pour la gravure des pyramides du niveau supérieur. On obtient bien ainsi, avec le masque décrit en figure 2, deux niveaux de gravure.

Au cours de la troisième étape on procède à l'enlèvement de la couche de passivation 440 et du masque dur 230. Cette opération est effectuée en plongeant le dispositif en cours de fabrication sur un substrat, généralement une tranche d'un matériau semi-conducteur du type de celles utilisées par l'industrie de la microélectronique, dans un milieu humide acide, par exemple à base d'acide fluorhydrique (HF). On obtient ainsi les motifs 110 en relief et la structuration de surface souhaitée.

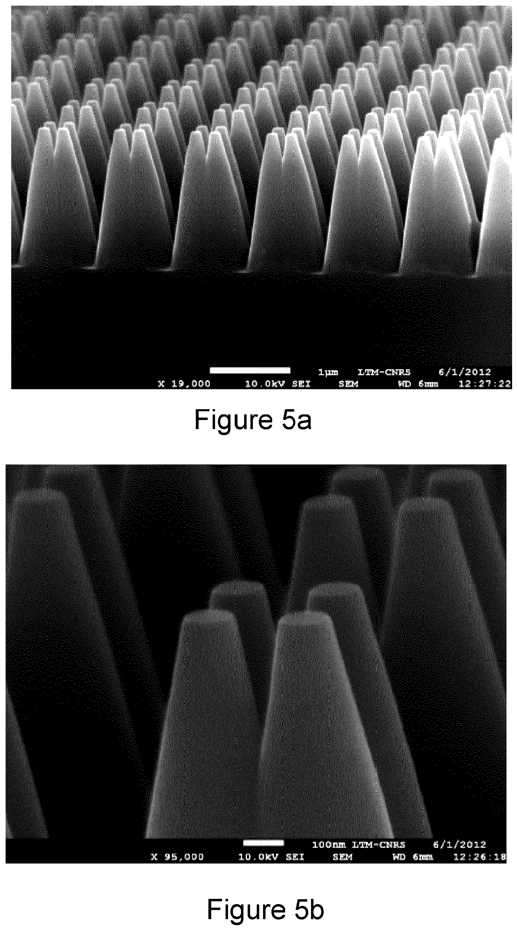

Les **figures 5a** et **5b** montrent des photos prises au microscope électronique à balayage (MEB) de pyramides à deux niveaux réalisées selon le procédé de l'invention. Quoique l'on puisse constater une certaine érosion des arêtes des pyramides due à la gravure plasma, notamment, comme montré sur la figure 5b, sur celles du niveau supérieur de taille plus petite, le procédé de l'invention permet bien en pratique d'obtenir la structuration de surface souhaitée 100. L'adjectif pyramidal s'entend ici d'un motif ayant la forme globale d'une portion de pyramide, ce qui peut inclure des imprécisions notamment dues à des défauts inhérents à la fabrication.

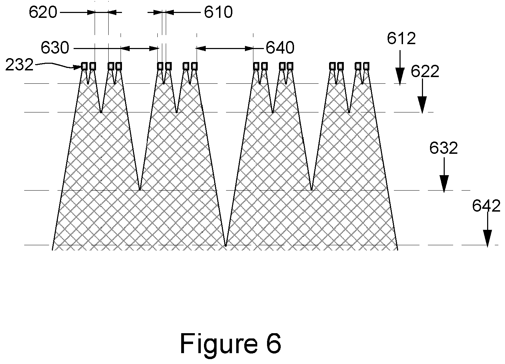

La **figure 6** illustre le fait que le procédé de l'invention, en combinaison avec la conception du masque de photolithographie correspondant, permet de graver plus de deux niveaux. La figure 6 montre le cas où l'on réalise un masque dur 232 ayant dans cet exemple quatre intervalles différents entre les motifs: 610, 620, 630 et 640. On obtient alors quatre niveaux de gravure différents : 612, 622, 632, et 642. D'une façon générale il y a autant de niveaux de gravure créés qu'il y a d'intervalles différents entre les motifs du masque dur.

Outre le tétrachlorure de silicium (SiCl$_4$) utilisé jusque-là pour décrire le procédé de l'invention et pour les expérimentations, tous les gaz suivants contenant du silicium sont susceptibles d'être employés comme gaz passivant pour mettre en œuvre l'invention, en complément du Cl$_2$:O$_2$ ou d'un autre plasma de base :

| Type de gaz : | Composition |
|---|---|
| chloré | SiCl$_4$, SiH$_3$Cl |
| bromé | SiBr$_4$, SiH$_3$Br |
| fluoré | SiF$_4$ |
| iodé | SiI$_4$ |
| bromo-chloré | SiBr$_2$Cl$_2$, SiCl$_3$Br |
| chloro-fluoré | SiClF$_3$ |

Le procédé a été présenté dans le cas de la gravure du silicium. Cependant, d'autres matériaux peuvent être gravés en utilisant le même concept et les même gaz passivant. Par exemple, des structures peuvent être réalisées en InP en utilisant un plasma de Cl2 :N2 et en ajoutant du SiCl4 pour la passivation.

En résumé, un protocole à suivre pour réaliser une structuration à plusieurs niveaux de la surface d'un matériau avec le procédé de l'invention peut être le suivant :

1-- Il faut tout d'abord déterminer la forme et les dimensions des motifs en relief de la structure anti-réfléchissante 100 qui confèrent à celle-ci les propriétés optiques souhaitées dans la gamme de longueur d'ondes considérée. L'invention ne fait pas d'hypothèse sur la façon dont ce résultat est obtenu. La forme et les dimensions sont, par exemple, celles indiquées dans la figure 1b. Ces formes et dimensions indicatives comprennent :

- $L_1$ la largeur 117 du motif 222 correspondant au sommet des pyramides supérieures
- $L_2$ la largeur 119 du pied des pyramides supérieures
- $P_{r1}$ la profondeur 115 de la pyramide supérieure
- $P_{r2}$ la profondeur 113 de la pyramide inférieure.
- P la période 111 des motifs
- $\theta$ l'angle 112 de la pente

Certaines de ces dimensions sont reliées avantageusement entre elles. Par exemple, on a :

$$L_1 = (L_2 - (4 \times P_{R1} / \text{tangente} (\theta)))/2$$

$$P = L_2 + (2 \times P_{R2}) / \text{tangente} (\theta))$$

$$\theta = \text{Arctangente} (( 2 \times P_{R2}) / (P - L_2)) = \text{Arctangente} ((2 \times P_{R1}) / (L_2 - 2L_1))$$

L'angle de gravure ($\theta$) est nécessairement le même pour les deux pyramides.

2-- On peut procéder ensuite à la conception du masque correspondant comme dans l'exemple de la figure 2. Il s'agit dans ce cas d'obtenir un réseau de zones formées de quatre carrés qu'on répète dans les deux dimensions du plan (les directions perpendiculaires x et y). Les dimensions à définir pour le masque sont la largeur des motifs 220 ($L_1$), la période 212 (P), et l'espace 213 entre les motifs 220 (E). Les dimensions L1 et P sont définies par les propriétés optiques qu'il faut conférer à la structure anti réfléchissante ou par les équations définies précédemment. L'espacement E est défini par l'équation E = (2 x $P_{R1}$) / tangente ($\theta$) = $L_2$ / 2 - $L_1$

3-- La couche du matériau constituant le masque dur 230 est déposée sur le matériau sous-jacent 102 dans lequel on va former l'empilement de pyramides tronquées formant la structure anti-réfléchissante comme dans l'exemple des figures 1a et 1b. On transfère dans cette couche, en utilisant les méthodes traditionnelles de photolithographie et de gravure, les motifs d'un masque de photolithographie définis comme dans l'exemple de la figure 2. L'épaisseur 232 du masque dur est choisie de telle sorte que celui-ci ne soit pas entièrement consommé pendant la gravure des motifs 110 et que d'éventuelles facettes ne descendent pas jusqu'au matériau à graver pendant la gravure. Dans l'exemple choisi pour illustrer l'invention, 100 nm d'oxyde de silicium ($SiO_2$), matériau constituant le masque dur, sont déposés sur un substrat fait de silicium 102. La sélectivité de la gravure plasma de type $Cl_2:SiCl_4:O_2$ entre le silicium et son oxyde étant excellente, l'épaisseur minimale du masque dur nécessaire pour graver plusieurs micromètres de silicium est inférieure aux 100 nm utilisés dans cet exemple.

4-- Les motifs définis au point 2 ci-dessus peuvent être par exemple formés dans le masque dur à partir d'une lithographie électronique définissant préalablement les motifs dans une résine sensible aux électrons. Ceux-ci sont ensuite transférés dans le masque dur par gravure plasma avant de procéder au retrait de la résine.

5-- Le procédé de gravure de l'invention utilise un gaz passivant, par exemple du tétrachlorure de silicium ($SiCl_4$), pour la fabrication des pyramides. En jouant sur les conditions du procédé, la pente 112, est adaptée pour correspondre aux dimensions définies au point 1 ci-dessus. L'angle $\theta$ de la pente de gravure peut être calculé en fonction des valeurs souhaitées d'espacement et de profondeur des motifs selon les formules données précédemment : $\theta$ = Arctangente (($2 \times P_{R2}$) / ($P - L_2$)) = Arctangente (($2 \times P_{R1}$) / ($L_2 / -2 L_1$))

On notera à nouveau que l'angle de gravure $\theta$ est le même pour les deux niveaux de pyramides. Les conditions du plasma de gravure sont par exemple celles qui ont été indiquées précédemment après la description de la figure 3.

6-- Le procédé de gravure de l'invention est adapté pour permettre un transfert complet des motifs du masque dur dans le matériau destiné à constituer les pyramides. Le temps de gravure est choisi pour être supérieur au temps nécessaire à la gravure d'une profondeur de matériau égale à la somme des profondeurs, 113 et 115, des pyramides. Par exemple, pour les pyramides dont les dimensions sont celles de la figure 1b, il faut pouvoir graver 1,575 $\mu$m de silicium. Pour une vitesse de gravure qui est typiquement de 550 nm/minute il faut donc prévoir un temps de gravure supérieur à 172 secondes. Ce qui est sans inconvénient puisque, comme on l'a vu, il y a autolimitation de la gravure quand la profondeur définie par l'espacement entre motifs est atteinte.

7-- Après gravure, on procède à un nettoyage afin de retirer la couche de passivation qui s'est formée pendant la gravure et le masque dur restant. Ceci peut être fait en une ou plusieurs étapes, par voie sèche ou humide. Par exemple, avec un masque dur fait d'oxyde de silicium ($SiO_2$) d'une épaisseur de 100 nm et avec un procédé de gravure plasma $SiCl_4:O_2:Cl_2$, un bain d'acide fluorhydrique (HF) dilué à 49% pendant 30 secondes à température ambiante peut être utilisé.

## Revendications

1. Procédé de réalisation de motifs comprenant des flancs inclinés à partir d'une face d'un substrat, comprenant :

   une formation d'un masque (230) de protection couvrant au moins deux zones (220) masquées de la face du substrat et définissant au moins un espace intermédiaire ;
   une gravure avec un plasma formant, sur au moins un espace intermédiaire, au moins un flanc incliné à partir de chaque zone masquée (220), la gravure comprenant la formation d'une couche de passivation (440), qui comprend une espèce chimique du substrat et est continue sur les flancs inclinés produisant une autolimitation de la gravure quand des flancs inclinés se rejoignent, et dans lequel la gravure est réalisée dans une chambre et comprend une introduction dans la chambre d'un gaz additionnel au plasma, ledit gaz additionnel comprenant des molécules d'une espèce chimique participant à la formation de la couche de passivation, la quantité de gaz additionnel dans la chambre étant contrôlée de sorte à ce que la chambre contienne tout au long de la gravure une quantité de molécules de l'espèce suffisante pour former la couche de passivation de manière continue, et dans lequel la gravure est configurée pour générer des molécules de l'espèce chimique du gaz additionnel au cours de la gravure du substrat.

2. Procédé selon la revendication 1 dans lequel la quantité de gaz additionnel est contrôlée de sorte à maintenir constante la croissance de la couche de passivation (440) au cours de la gravure.

3. Procédé selon l'une des revendications précédentes dans lequel la formation de la couche de passivation comprend une réaction de l'espèce chimique du gaz additionnel avec une autre espèce chimique du plasma.

4. Procédé selon la revendication 3 dans lequel l'autre espèce chimique comprend de l'oxygène.

5. Procédé selon l'une des revendications précédentes dans lequel le masque de protection est choisi pour ne pas réagir à la gravure.

6. Procédé selon l'une des revendications précédentes comprenant un enlèvement de la couche de passivation (440) et du masque (230) de protection après la gravure.

7. Procédé selon la revendication 6 dans lequel l'enlèvement comprend une attaque de la couche de passivation (440) et du masque de protection (230) par une solution acide.

8. Procédé selon l'une des revendications précédentes dans lequel les zones masquées (220) sont configurées de sorte à produire une première série de flancs inclinés ayant un premier niveau de profondeur dans le substrat et au moins une deuxième série de flancs inclinés ayant un niveau de profondeur différent du premier niveau.

9. Procédé selon la revendication 8 comprenant des jeux de quatre zones masquées (220) de section carrée et agencés en coins d'un carré, les jeux étant espacés selon une première direction (x) de la face du substrat avec un premier pas de répétition.

10. Procédé selon la revendication 9 dans lequel les jeux sont espacés selon une deuxième direction (y) de la face du substrat, perpendiculaire à la première direction (x), avec un deuxième pas de répétition.

11. Procédé selon la revendication 10 dans lequel le premier et le deuxième pas de répétition sont égaux.

12. Procédé selon l'une des revendications précédentes dans lequel le matériau gravé du substrat est du silicium (Si).

13. Procédé selon l'une des revendications précédentes dans lequel le masque de protection est en dioxyde de silicium (SiO2).

14. Procédé selon l'une des revendications précédentes dans lequel le plasma est à base de dichlore et de dioxygène (Cl2:O2).

15. Procédé selon l'une des revendications précédentes dans lequel la couche de passivation est à base de silicium.

16. Procédé selon l'une des revendications précédentes dans lequel le gaz additionnel contient l'espèce chimique silicium.

17. Procédé selon la revendication 16 dans lequel le gaz additionnel est du tétrachlorure de silicium (SiCl4).

**Patentansprüche**

1. Verfahren zur Herstellung von Motiven, umfassend geneigte Flanken, ausgehend von einer Fläche eines Substrats, umfassend:

ein Bilden einer Schutzmaske (230), die mindestens zwei maskierte Bereiche (220) der Fläche des Substrats bedeckt und mindestens einen Zwischenraum definiert;
einen Ätzvorgang mit einem Plasma, der ausgehend von jedem maskierten Bereich (220) auf mindestens einem Zwischenraum mindestens eine geneigte Flanke bildet, wobei der Ätzvorgang das Bilden einer Passivierungsschicht (440) umfasst, die eine chemische Spezies des Substrats umfasst und auf den geneigten Flanken durchgängig ist, die eine Selbstbeschränkung des Ätzvorgangs produzieren, wenn die geneigten Flanken zusammentreffen, und wobei der Ätzvorgang in einer Kammer durchgeführt wird und eine Einführung eines zusätzlichen Gases zum Plasma in der Kammer umfasst, wobei das zusätzliche Gas Moleküle einer chemischen Spezies umfasst, die an dem Bilden der Passivierungsschicht teilnehmen, wobei die Menge des zusätzlichen Gases in der Kammer kontrolliert wird, sodass die Kammer während des Ätzvorgangs eine Menge von Molekülen der Spezies enthält, die zum Bilden der Passivierungsschicht auf durchgängige Weise ausreicht, und wobei der Ätzvorgang konfiguriert ist, um im Laufe des Ätzvorgangs des Substrats Moleküle der chemischen Spezies des zusätzlichen Gases zu erzeugen.

2. Verfahren nach Anspruch 1, wobei die Menge des zusätzlichen Gases kontrolliert wird, sodass das Wachstum der Passivierungsschicht (440) im Laufe des Ätzvorgangs konstant gehalten wird.

3. Verfahren nach einem der vorstehenden Ansprüche, wobei das Bilden der Passivierungsschicht eine Reaktion der chemischen Spezies des zusätzlichen Gases mit einer anderen chemischen Spezies des Plasmas umfasst.

**4.** Verfahren nach Anspruch 3, wobei die andere chemische Spezies Sauerstoff umfasst.

**5.** Verfahren nach einem der vorstehenden Ansprüche, wobei die Schutzmaske ausgewählt wird, um bei dem Ätzvorgang nicht zu reagieren.

**6.** Verfahren nach einem der vorstehenden Ansprüche, umfassend ein Entfernen der Passivierungsschicht (440) und der Schutzmaske (230) nach dem Ätzvorgang.

**7.** Verfahren nach Anspruch 6, wobei das Entfernen einen Angriff auf die Passivierungsschicht (440) und die Schutzmaske (230) durch eine saure Lösung umfasst.

**8.** Verfahren nach einem der vorstehenden Ansprüche, wobei die maskierten Bereiche (220) konfiguriert sind, sodass eine erste Reihe von geneigten Flanken, die ein erstes Tiefenniveau in dem Substrat aufweist, und mindestens eine zweite Reihe von geneigten Flanken, die ein vom ersten Niveau verschiedenes Tiefenniveau aufweist, produziert wird.

**9.** Verfahren nach Anspruch 8, umfassend Gruppen von vier maskierten Bereichen (220) quadratischen Querschnitts und in Ecken eines Quadrats angeordnet, wobei die Gruppen entsprechend einer ersten Richtung (x) der Fläche des Substrats mit einem ersten Wiederholungsschritt beabstandet sind.

**10.** Verfahren nach Anspruch 9, wobei die Gruppen entsprechend einer zweiten Richtung (y) der Fläche des Substrats, senkrecht zur ersten Richtung (x), mit einem zweiten Wiederholungsschritt beabstandet sind.

**11.** Verfahren nach Anspruch 10, wobei der erste und der zweite Wiederholungsschritt gleich sind.

**12.** Verfahren nach einem der vorstehenden Ansprüche, wobei das geätzte Material des Substrats Silicium (Si) ist.

**13.** Verfahren nach einem der vorstehenden Ansprüche, wobei die Schutzmaske aus Siliciumdioxid ($SiO_2$) besteht.

**14.** Verfahren nach einem der vorstehenden Ansprüche, wobei das Plasma auf Dichlor und Disauerstoff ($Cl_2$:$O_2$) basiert ist.

**15.** Verfahren nach einem der vorstehenden Ansprüche, wobei die Passivierungsschicht auf Silicium basiert ist.

**16.** Verfahren nach einem der vorstehenden Ansprüche, wobei das zusätzliche Gas die chemische Spezies Silicium enthält.

**17.** Verfahren nach Anspruch 16, wobei das zusätzliche Gas Siliciumtetrachlorid ($SiCl_4$) ist.

**Claims**

**1.** A method for making patterns comprising sides inclined from a face of a substrate, comprising:

forming a protective mask (230) covering at least two masked areas (220) of the face of the substrate and defining at least one intermediate space;
etching with a plasma forming, on at least one intermediate space, at least one side inclined from each masked area (220), the etching comprising the formation of a passivation layer (440), which comprises a chemical species of the substrate and is continuous on the inclined sides producing a self-limitation of the etching when the inclined sides meet, and wherein the etching is carried out in a chamber and comprises an introduction into the chamber of an additional gas to the plasma, said additional gas comprising molecules of a chemical species participating in the formation of the passivation layer, the amount of additional gas in the chamber being controlled so that the chamber contains throughout the etching a sufficient amount of molecules of the species to continuously form the passivation layer, and wherein the etching is configured to generate molecules of the chemical species of the additional gas during the etching of the substrate.

**2.** The method according to claim 1 wherein the amount of additional gas is controlled so as to keep the growth of the passivation layer (440) constant during etching.

3. The method according to one of the preceding claims, wherein the formation of the passivation layer comprises a reaction of the chemical species of the additional gas with another chemical species of the plasma.

4. The method according to claim 3 wherein the other chemical species comprises oxygen.

5. The method according to one of the preceding claims, wherein the protective mask is selected so as not to react in the etching.

6. The method according to one of the preceding claims, comprising removing the passivation layer (440) and the protective mask (230) after etching.

7. The method according to claim 6 wherein the removal comprises an attack of the passivation layer (440) and the protective mask (230) with an acid solution.

8. The method according to one of the preceding claims wherein the masked areas (220) are configured so as to produce a first series of inclined sides having a first level of depth in the substrate and at least one second series of inclined sides having a depth level different from the first level.

9. The method according to claim 8 comprising sets of four masked areas (220) of square section and arranged in the corners of a square, the sets being spaced in a first direction (x) of the face of the substrate with a first repeat pitch.

10. The method according to claim 9 wherein the sets are spaced in a second direction (y) of the face of the substrate, perpendicular to the first direction (x), with a second repeat pitch.

11. The method according to claim 10 wherein the first and second repeat pitches are equal.

12. The method according to one of the preceding claims, wherein the etched material of the substrate is silicon (Si).

13. The method according to one of the preceding claims, wherein the protective mask is made of silicon dioxide ($SiO_2$).

14. The method according to one of the preceding claims, wherein the plasma is based on chlorine and dioxygen ($Cl_2$:$O_2$).

15. The method according to one of the preceding claims, wherein the passivation layer is based on silicon.

16. The method according to one of the preceding claims, wherein the additional gas contains the chemical species silicon.

17. The method according to claim 16 wherein the additional gas is silicon tetrachloride ($SiCl_4$).

# Art Antérieur

## Figure 1a

## Figure 1b

Figure 2

Figure 3

Vue de Dessus   Coupe Transversale

Figure 4

Figure 5a

Figure 5b

Figure 6

**EP 2 784 803 B1**

## RÉFÉRENCES CITÉES DANS LA DESCRIPTION

### Littérature non-brevet citée dans la description

- *Optics Letters,* 01 Mai 2010, vol. 35 (9

- Fabrication of V-groove gratings in Inp by inductively coupled plasma etching with SiCI4/Ar. Semiconductor Science and Technology. IOP publishing Ltd, 28 Novembre 2005, vol. 21, L01-05